(19) **Europäisches Patentamt / European Patent Office / Office européen des brevets**

(11) **EP 4 455 692 B1**

(12) # EUROPEAN PATENT SPECIFICATION

(45) Date of publication and mention
of the grant of the patent:
**28.01.2026  Bulletin 2026/05**

(21) Application number: **22921325.1**

(22) Date of filing: **22.04.2022**

(51) International Patent Classification (IPC):
**G01R 31/00** (2006.01)

(52) Cooperative Patent Classification (CPC):
**G01N 3/08; G01R 29/0821; G01R 31/003;**
G01N 2203/0236; G01R 31/001; G01R 31/002

(86) International application number:
**PCT/CN2022/088450**

(87) International publication number:
**WO 2023/137893 (27.07.2023 Gazette 2023/30)**

(54) **RELIABILITY TEST APPARATUS COUPLING ELECTROMAGNETIC ENVIRONMENT AND STRESS ENVIRONMENT**

ZUVERLÄSSIGKEITSTESTVORRICHTUNG ZUR KOPPLUNG EINER ELEKTROMAGNETISCHEN UMGEBUNG UND EINER STRESSUMGEBUNG

APPAREIL DE TEST DE FIABILITÉ COUPLANT UN ENVIRONNEMENT ÉLECTROMAGNÉTIQUE ET UN ENVIRONNEMENT DE CONTRAINTE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **24.01.2022  CN 202210083474**

(43) Date of publication of application:
**30.10.2024  Bulletin 2024/44**

(73) Proprietor: **National Industrial Innovation Center of Polymer**
**Materials Co., Ltd**
**Guangzhou Hi-Tech Industrial Development Zone**
**Guangzhou, Guangdong 510663 (CN)**

(72) Inventors:
• **LIU, Jie**
  **Guangzhou, Guangdong 510663 (CN)**
• **WU, Bo**
  **Guangzhou, Guangdong 510663 (CN)**
• **PANG, Chenghuan**
  **Guangzhou, Guangdong 510663 (CN)**
• **LI, Weiling**
  **Guangzhou, Guangdong 510663 (CN)**
• **NING, Hongtao**
  **Guangzhou, Guangdong 510663 (CN)**

• **SHAO, Haibo**
  **Guangzhou, Guangdong 510663 (CN)**
• **WANG, Shuting**
  **Guangzhou, Guangdong 510663 (CN)**

(74) Representative: **Petraz, Gilberto Luigi et al**
**GLP S.r.l.**
**Viale Europa Unita, 171**
**33100 Udine (IT)**

(56) References cited:
WO-A1-02/056041          WO-A1-2020/181320
CN-A- 103 630 774       CN-A- 103 630 774
CN-A- 105 243 834       CN-A- 105 973 690
CN-A- 105 973 690       CN-A- 106 769 498
CN-A- 106 908 673       CN-A- 108 508 311
CN-A- 108 982 976       CN-A- 108 982 976
CN-A- 110 646 770       CN-A- 110 715 865
CN-A- 113 419 114       CN-U- 205 374 636
US-A- 5 998 799         US-A1- 2010 216 409
US-B1- 6 360 621

- **VOICU VIORICA ET AL: "Modeling the Electromagnetic Field Distribution in a Shielded Enclosure Lined with Radio-Frequency Absorbers", 2018 INTERNATIONAL CONFERENCE ON APPLIED AND THEORETICAL ELECTRICITY (ICATE), IEEE, 4 October 2018 (2018-10-04), pages 1 - 5, XP033459466, DOI: 10.1109/ICATE.2018.8551389**

- **SABIH G�ZELG�Z ET AL: "Time frequency analysis of noise generated by electrical loads in PLC", TELECOMMUNICATIONS (ICT), 2010 IEEE 17TH INTERNATIONAL CONFERENCE ON, IEEE, PISCATAWAY, NJ, USA, 4 April 2010 (2010-04-04), pages 864 - 871, XP031685457, ISBN: 978-1-4244-5246-0**

**Description**

TECHNICAL FIELD

The present invention relates to the field of reliability test, and in particular to a reliability test apparatus for coupling an electromagnetic environment and a stress environment.

BACKGROUND

With the development of the modern information technology, modern electronic devices are developing increasingly precisely, and an electromagnetic environment that the electronic devices are in is becoming increasingly complicated. The electronic devices and power devices both actively or passively emit electromagnetic waves under normal working conditions. An increase in power of communication, a radar, and electromagnetic interference within the electronic devices enhances a near-field environment generated by device radiation. In addition, an electromagnetic environment generated by various external electronic warfare devices and electromagnetic attack weapons may also threaten normal working of other sensitive components inside the electronic devices. Therefore, in the design of some components and structures of cutting-edge products, changes in various performance parameters of materials used in complicated electromagnetic environments also become a factor to be considered.

Currently, there is almost no dedicated research on a stress performance change of a tested device or material in the complicated electromagnetic environment. To actively respond to this impact, an electromagnetic environment and a stress environment that are approximate to reality and meet performance testing requirements for the device and material need to be built. Building the electromagnetic environment means that a target electromagnetic environment is built as realistically as possible by comprehensively using various technical means, requirements for building the testing electromagnetic environment may be specified through testing plans, and various parameters such as a quantity of radiation sources, operating frequency bands, working parameters are usually specified. At present, there are mainly three mainstream methods for building the electromagnetic environment: 1. entire-physical building using real weapons and equipment; 2. semi-physical building using various signal simulators and distributed interactive simulation technologies; 3. full mathematical model building using computer simulation and the simulation technology. These three methods for building the electromagnetic environment each have advantages and disadvantages, and are proper for different development stages of the electronic device.

WO-A1-02/056041 discloses a reliability test apparatus for coupling an electromagnetic environment and a stress environment as of the preamble of claim 1.

This document discloses a climatic chamber, which can change factors such as temperature, humidity, pressure, and atmosphere to ensure that the treatment can be carried out under different climatic conditions. However, the changed pressure is gas pressure, and the pressure applied to the device is perpendicular to the surface of the device, that is, the stress directions are diverse. Alternatively, a vibrator is installed in the chamber to simulate the mechanical vibration of the tested device and/or introduce additional mode stirring, and to measure the radio, acoustic, or optical properties in a vibrating environment.

At present, there is a lack of a test apparatus for coupling the complicated electromagnetic and stress environment, and a material and a device reliability test apparatus with complicated working conditions and a complicated electromagnetic environment need to be developed urgently.

SUMMARY

To resolve a problem of no stress performance testing manner for a sample to be tested in a complicated electromagnetic environment, the present invention provides a reliability test apparatus for coupling an electromagnetic environment and a stress environment. The invention is set out in the appended set of claims.

Technical solutions used in the present invention are as follows: a reliability test apparatus for coupling an electromagnetic environment and a stress environment includes: a shielding compartment, an electromagnetic simulation system, a stress application system, a data collection system, and a control system, where

an inner side of the shielding compartment is provided with a microwave absorption layer and a shielding layer;
the electromagnetic simulation system is used for emitting electromagnetic waves in the shielding compartment, so as to simulate an electromagnetic environment;
the stress application system is used for fixing a sample to be tested in the shielding compartment, and applying stress to the sample to be tested;
the data collection system is used for collecting electromagnetic environment data in the shielding compartment and acting force data of the sample to be tested after the application of stress thereto; and
the control system is used for controlling, according to a preset test program and the data collected by the data collection system, the electromagnetic simulation system and the stress application system to execute reliability test on the sample to be tested.

The stress application system includes a loading apparatus, an upper connecting rod, and a lower connecting rod, a lower end of the upper connecting rod and an upper end of the lower connecting rod are both provided with sample fixtures, a lower end of the lower connecting rod is firmly connected to the shielding compartment, an upper end of the upper connecting rod is connected to the loading apparatus, and the loading apparatus is used for applying an acting force to the sample to be tested; and the sample fixture is used for fixing the sample to be tested.

the loading apparatus includes a tension application component and a pressure application component, the tension application component is movably connected to the upper connecting rod through a lever, and the pressure application component is firmly connected to the upper connecting rod.

Preferably, the electromagnetic simulation system includes a signal simulator, a filter, and a radiation array that are sequentially connected, the radiation array is disposed inside the protective cover, the radiation array includes several horn antennas, and a transmitting end of the horn antenna faces the sample to be tested; and the signal simulator is used for generating electromagnetic signals that simulate the electromagnetic environment, and the filter is used for filtering out electromagnetic signals in a non-target frequency band.

Preferably, the data collection system further includes a second electromagnetic radiation detector, and the second electromagnetic radiation detector is used for collecting electromagnetic environment data outside the shielding compartment and transmitting the electromagnetic environment data to the control system.

Preferably, the shielding compartment is provided with a protective cover, and the sample fixture is disposed inside the protective cover.

Preferably, the sample fixture is provided with at least one tightening screw and at least one anti-slip screw, the tightening screw is used for fixing the sample to be tested, and the anti-slip screw is used for preventing the sample to be tested from sliding.

Preferably, the electromagnetic simulation system and the stress application system work independently of each other.

Preferably, the control system includes an electromagnetic control module and a stress control module. The electromagnetic control module and the stress control module are electrically connected;

the electromagnetic control module includes an electromagnetic control panel used for displaying and controlling the electromagnetic control module, and the stress control module includes a stress control panel used for displaying and controlling the stress control module.

Preferably, the shielding compartment is provided with a plurality of compartments, each of the compartments is separately provided with the electromagnetic simulation system and the stress application system, and there is the microwave absorption layer and the shielding layer between adjacent compartments.

Beneficial effects of the present invention are as follows.

By means of the reliability test apparatus for coupling the electromagnetic environment and the stress environment, the stress performance of a sample to be tested can be tested in a complex electromagnetic environment, providing a rapid, reliable and stable test apparatus for the electromagnetic reliability of an electronic device and a material. The electromagnetic simulation system and the stress application system can generate the electromagnetic environment and the stress environment, which can be simulated separately, or one or two systems can be enabled based on actual use conditions, so that the sample to be tested undergoes reliability test under a plurality of operating conditions in a single or two environments, and material life test better conforms to an actual use simulation test, and the electromagnetic environment simulation technology can be promoted to the field of material reliability test characterization.

Preferably, the shielding compartment increases stability and sealing performance of an electromagnetic performance testing environment by using the microwave absorption layer and the shielding layer, so that electromagnetic reliability test is performed more easily and flexibly, and accuracy of a test process and test data is improved.

Preferably, a broadband horn antenna array is used in the electromagnetic simulation system, so that a frequency band of the electromagnetic simulation system is wider and a simulated electromagnetic environment power is greater.

Preferably, the separate protective cover can prevent the sample to be tested from bursting and damaging a testing device under an action of the stress, and affecting testing of another sample to be tested.

## BRIEF DESCRIPTION OF DRAWINGS

The present invention is further described with reference the accompanying drawings of the specification, where

FIG. 1 is a schematic structural diagram of a reliability test apparatus for coupling an electromagnetic environment and a stress environment according to an embodiment of the present invention;
FIG. 2 is a schematic diagram of a box body according to an embodiment of the present invention; and
FIG. 3 is a schematic structural diagram of an electromagnetic simulation system and a stress application system within a single compartment according to another embodiment of the present invention.

In the drawings: 1. box body; 101. box door; 102. handle; 103. wheel; 104. electric control cabinet; 2. shielding compartment; 201. microwave absorption layer; 202. shielding layer; 301. radiation array; 302. horn antenna; 303. filter; 304. signal simulator; 305. second electromagnetic radiation detector; 401. loading apparatus; 402. upper connecting rod; 403. lower connecting rod; 404. sample fixture; 405. safety bolt; 406. tightening screw; 407. anti-slip screw; 408. tension application component; 409. pressure application component; 501. electromagnetic sensor; 502. force value sensor; 6. protective cover; 701. electromagnetic control panel; 702. stress control panel; 8. compartment; 9. sample to be tested.

## DETAILED DESCRIPTION OF EMBODIMENTS

The technical solutions in the embodiments of the present invention are clearly and completely described below with reference to the accompanying drawings in the embodiments of the present invention. Apparently, the described embodiments are merely some rather than all of the embodiments of the present invention. Based on the embodiments of the present invention, all other embodiments obtained by those of ordinary skill in the art without creative effort fall within the protection scope of the present invention.

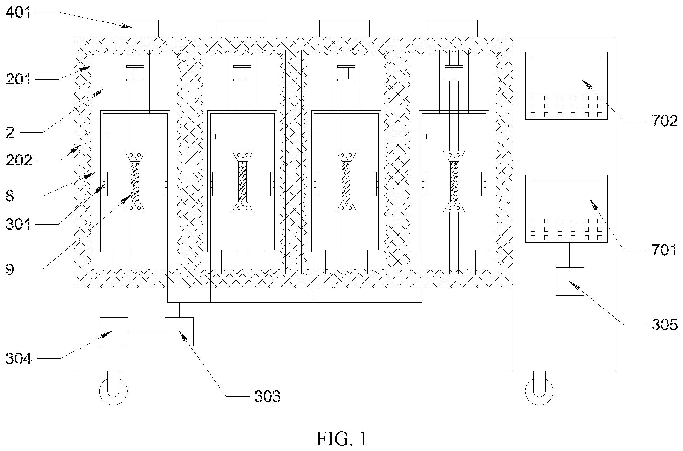

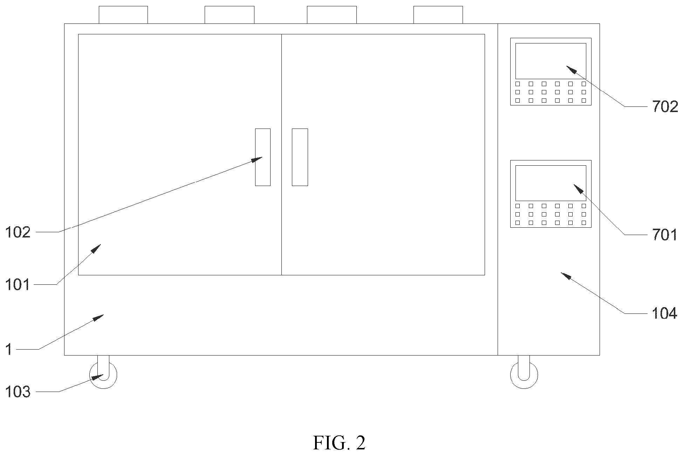

FIG. 1 to FIG. 3 show one embodiment of the present invention. A reliability test apparatus for coupling an electromagnetic environment and a stress environment in this embodiment includes: a shielding compartment 2, an electromagnetic simulation system, a stress application system, a data collection system, and a control system.

An inner side of the shielding compartment 2 is provided with a microwave absorption layer 201 and a shielding layer 202.

The electromagnetic simulation system is used for emitting electromagnetic waves inside the shielding compartment 2 to simulate the electromagnetic environment.

The stress application system is used for fixing a sample to be tested inside the shielding compartment and applying a stress to the sample to be tested. The stress application system includes a loading apparatus 401, an upper connecting rod 402, and a lower connecting rod 403. A lower end of the upper connecting rod 402 and an upper end of the lower connecting rod 403 are both provided with sample fixtures 404. A lower end of the lower connecting rod 403 is firmly connected to the shielding compartment 2, an upper end of the upper connecting rod 402 is connected to the loading apparatus 401, and the loading apparatus 401 is used for applying an acting force to the sample to be tested 9. The sample fixture 404 is used for fixing two ends of the sample to be tested 9 to prevent the two ends from bending or twisting, and to ensure that the acting force is transmitted along an axial direction of the sample to be tested 9.

As another example of this embodiment, a specific structure of the sample fixture can be improved to an extent according to an actual situation. If the sample to be tested is a component or a device, and a lower fixture is firmly fastened, an upper fixture may be omitted, to ensure that the sample to be tested does not bend or twist.

The data collection system is used for collecting electromagnetic environment data inside the shielding compartment 2 and acting force data of the sample to be tested after a stress is applied. **In** this embodiment, the data collection system collects the acting force output by the loading apparatus 401 as the acting force data of the sample to be tested after the stress is applied. The data collection system includes an electromagnetic sensor 501 and a force value sensor 502.

The control system is used for controlling, according to a preset test program and the data collected by the data collection system, the electromagnetic simulation system and the stress application system to execute reliability test on the sample to be tested 9.

By means of the reliability test apparatus for coupling the electromagnetic environment and the stress environment, the stress performance of a sample to be tested 9 can be tested in a complex electromagnetic environment, providing a rapid, reliable and stable test apparatus for the electromagnetic reliability of an electronic device and a material, and promoting an electromagnetic environment simulation technology to the field of material reliability test characterization.

The shielding compartment 2 increases stability and sealing performance of an electromagnetic performance testing environment by using the microwave absorption layer 201 and the shielding layer 202, so that electromagnetic reliability test is more easily and flexibly performed, and accuracy of a test process and test data is improved.

Preferably, the shielding compartment 2 is provided with a protective cover 6, and the sample fixture 404 is disposed inside the protective cover 6. The separate protective cover 6 can prevent the sample to be tested 9 from bursting and damaging a testing device under an action of the stress, and affecting testing of another sample to be tested 9.

Preferably, the electromagnetic simulation system includes a signal simulator 304, a filter 303, and a radiation array 301 that are sequentially connected. The radiation array 301 is disposed inside the protective cover 6, and the radiation array 301 includes several horn antennas 302. A transmitting end of the horn antenna 302 faces the sample to be tested 9.

The signal simulator 304 is used for generating electromagnetic signals that simulate the electromagnetic environment. The filter 303 is used for filtering out electromagnetic signals in a non-target frequency band.

Preferably, the data collection system further includes a second electromagnetic radiation detector 305, and the second electromagnetic radiation detector 305 is used for collecting electromagnetic environment data outside the shielding compartment 2 and transmitting the electromagnetic environment data to the control system. As a preferred example, the data collection system collects electromagnetic environment data outside the shielding compartment 2, compares the electromagnetic environment data with electromagnetic data inside the shielding compartment and analyzes electromagnetic environment data, and evaluates a shielding effect of the shielding compartment, reducing a problem of inaccurate testing caused by the shielding effect.

Preferably, the stress application system further includes a safety bolt 405, and the safety bolt 405 is disposed at one end of the upper connecting rod 402.

Preferably, the sample fixture 404 is provided with at least one tightening screw 406 and at least one anti-slip screw 407. The tightening screw 406 is used for fixing the sample to be tested 9, and the anti-slip screw 407 is used for preventing the sample to be tested 9 from sliding.

Preferably, the electromagnetic simulation system and the stress application system work independently of each other.

Preferably, the control system includes an electromagnetic control module and a stress control module. The electromagnetic control module and the stress control module are electrically connected.

The electromagnetic control module includes an electromagnetic control panel 701 for displaying and controlling the electromagnetic control module, and the stress control module includes a stress control panel 702 for displaying and controlling the stress control module.

Preferably, the shielding compartment 2 is provided with a plurality of compartments 8, each of the compartments 8 is separately provided with the electromagnetic simulation system and the stress application system, and there is the microwave absorption layer 201 and the shielding layer 202 between adjacent compartments 8.

Preferably, the loading apparatus 401 includes a tension application component 408 and a pressure application component 409. The tension application component 408 is movably connected to the upper connecting rod 402 through a lever, and the pressure application component 409 is firmly connected to the upper connecting rod 402.

The sample to be tested 9 in this embodiment may be a product, a device, component, or a standard test sample made of a separate material.

Preferably, the reliability test apparatus for coupling the electromagnetic environment and the stress environment further includes a box body 1, and the shielding compartment 2, the data collection system, and the control system are all disposed inside the box body 1.

The box body 1 is provided with a box door 101, a handle 102 is provided on the box door 101, wheels 103 are disposed below the box body 1, and the wheels 103 are used for transportation and movement of the box body 1.

The box body 1 is provided with an electrical control cabinet 104, and one side of the box door 101 is provided with an electromagnetic control panel 701 and a stress control panel 702.

A laminated conductive film is disposed between the box body 1 and the box door 101, to improve the electromagnetic isolation effect of the shielding compartment 2 and prevent static electricity from accumulating on the box door 101.

As another embodiment of the present invention, a reliability test apparatus for coupling a stress environment and an electromagnetic radiation environment is provided. For the apparatus, closed space in a specific region is used as an experimental platform, electromagnetic environment signals are built using various signal simulators 304, and a required three-dimensional electromagnetic signal environment is flexibly disposed by changing parameters of various simulators. A loading apparatus 401 can be used to perform stress simulation on a sample to be tested 9. An electromagnetic environment and a stress environment may be simulated separately, or one or two systems may be enabled according to actual use conditions, so that the sample to be tested 9 undergoes a simulation test in a separate environment or the two environments.

The present invention provides a reliability test apparatus for coupling a stress environment and an electromagnetic radiation environment, and the apparatus includes a box body 1, a box door 101, a handle 102, wheels 103, an electromagnetic simulation system, a stress application system, and a control system. The present invention uses the following electromagnetic and stress dual environment coupling simulation system, which includes an electromagnetic simulation system and a stress application system, respectively. The electromagnetic simulation system and the stress application system are separately connected to the control system.

A front end face of the box body 1 is provided with the box door 101, the box door 101 is provided with the handle 102. In this embodiment, the box body 1 is provided with four compartments 8. A support column is disposed between the protective cover 6 and the box body 1, and the support column is used for fixing the protective cover 6 inside the box body 1.

The box body 1 provides a non-echo electromagnetic shielding anechoic chamber for building a complicated electromagnetic environment. Shielding by the anechoic chamber is mainly implemented through a microwave absorption layer 201 and a shielding layer 202. The microwave absorption layer 201 is a sawtooth-shaped absorbing wave material.

The electromagnetic simulation system mainly includes the following parts: a radiation array 301, a horn antenna 302, a signal simulator 304, a filter 303, an electromagnetic sensor 501, an electromagnetic control module, and an electromagnetic control panel 701. The radiation array 301 includes eight horn antennas 302 that are distributed in pairs on two sides of a single compartment 8. The electromagnetic sensor 501 is installed on a middle inner wall of the protective cover 6, the protective cover 6 is disposed on the support column, the signal simulator 304, and the filter 303. The electromagnetic control panel 701 is installed on the electromagnetic control module and can display parameter settings and monitoring of electromagnetic radiation data of a device.

The radiation array 301 implements simulation of a target radiation signal and formulates a target electromagnetic environment through unit combination.

The horn antenna 302 radiates an electromagnetic signal to an internal shielding region of the protective cover 6 through the horn antenna 302.

The electromagnetic sensor 501 collects and monitors an electromagnetic signal parameter emitted by the radiation array 301.

The filter 303 filters out the impact of a non-target electromagnetic environment frequency band signal on testing.

The horn antenna 302 and the electromagnetic control module implement bidirectional communication through a signal transmission module. A dynamic change in the electromagnetic environment leads to a change in a signal source through the electromagnetic control module, thereby changing a transmission type, parameter, and the like.

The electromagnetic control module is connected to the electromagnetic control panel 701 through the electromagnetic sensor 501, to implement real-time monitoring of the electromagnetic environment inside the protective cover 6.

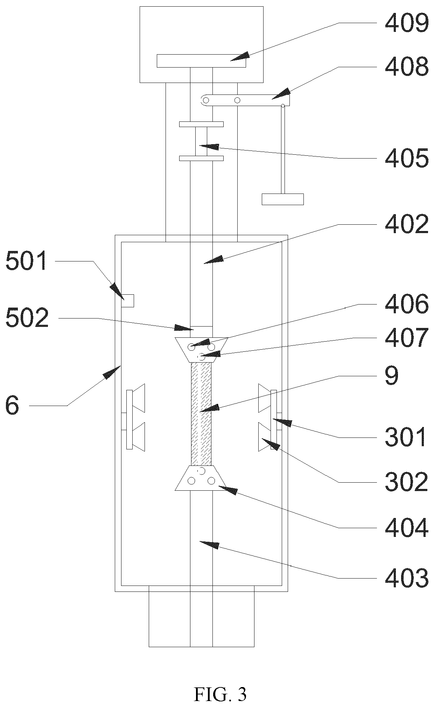

Refer to FIG. 3. The stress application system mainly includes the following parts: the safety bolt 405, the upper connecting rod 402, the sample fixture 404, the tightening screw 406, the anti-slip screw 407, the lower connecting rod 403, the loading apparatus 401, the stress control module, and the stress control panel 702. The upper connecting rod 402 and the lower connecting rod 403 are connected to the sample fixtures 404, and the sample to be tested 9 can be fastened in the sample fixture 404 through the tightening screws 406 and the anti-slip screws 407. The sample fixture 404 can prevent sliding, bending, and twisting of the sample to be tested 9 and ensure that loading is transmitted along an axial direction of the sample to be tested 9. The loading apparatus 401 is located on a rear side of the compartment 8, a designated mass weight at one end is transferred to the upper connecting rod 402 through the lever by using a balance lever, to apply a specific tension or pressure to the sample to be tested 9. In this embodiment, the loading apparatus 401 can apply an acting force of 10N-1000N to the sample to be tested 9.

In another embodiment, the acting force may alternatively be applied through the loading apparatus 401 including an electric apparatus.

Specifically, the above reliability test apparatus for coupling an electromagnetic environment and a stress environment performs steps for conducting reliability test as follows:

S1: demonstrating and designing test parameters based on a working condition and characteristic of the sample to be tested 9, where the test parameters include an electromagnetic parameter and a stress parameter, including only one parameter alone or a combination of parameters;

S2: fastening an upper end and a lower end of the sample to be tested 9 to the sample fixture 404, and closing the box door 101;

S3: working, by the data collection system to collect environmental parameters inside and outside the shielding compartment 2; and

S4: controlling based on the environmental parameters, by the control system, the electromagnetic simulation system and the stress application system to simulate a testing environment based on the testing parameters, and performing testing on the sample to be tested 9 fastened by the sample fixture 404.

In this embodiment, a wired end of the horn antenna 302 is preferably but not limited to being connected to an output end of a first electromagnetic radiation detector through a low-loss specialized radio frequency cable with a shielding function. A through hole is provided in the shielding compartment 2 for the radio frequency cable to pass through. Preferably, an electromagnetic shielding protective cover is disposed in the through hole, to prevent an external interference signal from entering the shielding compartment 2.

(1) Shielding effect of the anechoic chamber:

$$0.1 \text{ GHz–8 GHz: } \geq 800 \text{ dB;}$$

$$8 \text{ GHz–18 GHz: } \geq 70 \text{ dB;}$$

$$18 \text{ GHz–40 GHz: } \geq 60 \text{ dB;}$$

(2) Analog signal types: a communication signal, a navigation signal, a broadcasting signal, a radar signal, a satellite communication signal, an interference signal, a clutter signal, a multipath signal, and the like; and

(3) Frequency bands of the four horn antenna arrays 302: 60 GHz-70 GHz, 70 GHz-80 GHz, 80 GHz-90 GHz, and 90 GHz-100 GHz.

As can be seen from the above, the embodiments of the present invention have the following beneficial effects:

1. the box body and the protective cover include both a shielding and wave absorbing material as well as a thermal insulation material, are provided with double-layer electromagnetic protection, and provide a possibility of temperature and electromagnetic performance, enhancing accuracy and safety of a testing process and testing data;

2. according to the present invention, a test apparatus for a material-level electromagnetic reliability and service life, which extends an electromagnetic environment simulation technology from product electromagnetic compatibility performance testing to the field of material reliability test characterization;

3. The electromagnetic simulation system of the present invention meets the requirements for generating a wideband and high-power electromagnetic environment, implementing the building of the electromagnetic environment. In addition, the use of the high-frequency band can accelerate material aging, shorten detection time, and save time and costs;

4. The electromagnetic simulation system and the stress application system can generate the electromagnetic environment and the stress environment, which can be simulated separately, or one or two systems can be enabled based on actual use conditions, so that the sample to be tested undergoes reliability test under a plurality of operating conditions in a single or two environments, and material life test better conforms to an actual use simulation test, and a test result have more reference and research values; and

5. according to the embodiments of the present invention, accelerated aging testing can be performed in both the environment electromagnetic and the stress environment, helping shorten a test cycle.

In the above specific embodiments, the objectives, technical solutions, and beneficial effects of the present invention are further described in detail. It should be understood that the above descriptions are merely specific embodiments of the present invention, but are not intended to limit the protection scope of the present invention which is defined by the appended claims.

**Claims**

1. A reliability test apparatus for coupling an electromagnetic environment and a stress environment, comprising: a shielding compartment (2), an electromagnetic simulation system, a stress application system, a data collection system, and a control system, wherein

    an inner side of the shielding compartment (2) is provided with a microwave absorption layer (201) and a shielding layer (202);
    the electromagnetic simulation system is used for emitting electromagnetic waves in the shielding compartment (2), so as to simulate an electromagnetic environment;
    the stress application system is used for fixing a sample to be tested (9) in the shielding compartment (2), and applying stress to the sample to be tested (9);

the data collection system is used for collecting electromagnetic environment data in the shielding compartment (2) and acting force data of the sample to be tested (9) after the application of stress thereto; and

the control system used for controlling, according to a preset test program and the data collected by the data collection system, the electromagnetic simulation system and the stress application system to execute reliability test on the sample to be tested (9);

**characterized in that**, the stress application system comprises a loading apparatus (401), an upper connecting rod (402), and a lower connecting rod (403), a lower end of the upper connecting rod (402) and an upper end of the lower connecting rod (403) are both provided with sample fixtures (404), a lower end of the lower connecting rod (403) is firmly connected to the shielding compartment (2), an upper end of the upper connecting rod (402) is connected to the loading apparatus (401), and the loading apparatus (401) is used for applying an acting force to the sample to be tested (9); and the sample fixture (404) is used for fixing the sample to be tested (9); and

the loading apparatus (401) comprises a tension application component (408) and a pressure application component (409), the tension application component (408) is movably connected to the upper connecting rod (402) through a lever, and the pressure application component (409) is firmly connected to the upper connecting rod (402).

2. The reliability test apparatus for coupling an electromagnetic environment and a stress environment according to claim 1, **characterized in that**, the electromagnetic simulation system comprises a signal simulator (304), a filter (303), and a radiation array (301) that are sequentially connected, the radiation array (301) is disposed inside the protective cover, the radiation array (301) comprises several horn antennas (302), and a transmitting end of the horn antenna (302) faces the sample to be tested (9); wherein the signal simulator (304) is used for generating electromagnetic signals that simulate the electromagnetic environment, and the filter (303) is used for filtering out electromagnetic signals in a non-target frequency band.

3. The reliability test apparatus for coupling an electromagnetic environment and a stress environment according to claim 1, **characterized in that**, the data collection system further comprises a second electromagnetic radiation detector (305), and the second electromagnetic radiation detector (305) is used for collecting electromagnetic environment data outside the shielding compartment (2) and transmitting the electromagnetic environment data to the control system.

4. The reliability test apparatus for coupling an electromagnetic environment and a stress environment according to claim 1, **characterized in that**, the shielding compartment (2) is provided with a protective cover, and the sample fixture (404) is disposed inside the protective cover.

5. The reliability test apparatus for coupling an electromagnetic environment and a stress environment according to claim 1, **characterized in that**, the sample fixture (404) is provided with at least one tightening screw and at least one anti-slip screw, the tightening screw is used for fixing the sample to be tested (9), and the anti-slip screw is used for preventing the sample to be tested (9) from sliding.

6. The reliability test apparatus for coupling an electromagnetic environment and a stress environment according to claim 1, **characterized in that**, the electromagnetic simulation system and the stress application system work independently of each other.

7. The reliability test apparatus for coupling an electromagnetic environment and a stress environment according to claim 6, **characterized in that**, the control system comprises an electromagnetic control module and a stress control module; the electromagnetic control module and the stress control module are electrically connected; and
the electromagnetic control module comprises an electromagnetic control panel (701) used for displaying and controlling the electromagnetic control module, and the stress control module comprises a stress control panel (702) used for displaying and controlling the stress control module.

8. The reliability test apparatus for coupling an electromagnetic environment and a stress environment according to any one of claims 1 to 7, **characterized in that**, the shielding compartment (2) is provided with a plurality of compartments, each of the compartments is separately provided with the electromagnetic simulation system and the stress application system, and there is the microwave absorption layer (201) and the shielding layer (202) between adjacent compartments.

**Patentansprüche**

1. Zuverlässigkeitstestvorrichtung zur Kopplung einer elektromagnetischen Umgebung und einer Stressumgebung, umfassend: eine Abschirmungsabteilung (2), ein elektromagnetisches Simulationssystem, ein Stressaufbringungssystem, ein Datensammelsystem und ein Steuerungssystem, worin

eine Innenseite der Abschirmungsabteilung (2) mit einer Mikrowellenabsorptionsschicht (201) und einer Abschirmungsschicht (202) versehen ist;
das elektromagnetische Simulationssystem zum Emittieren von elektromagnetischen Wellen in der Abschirmungsabteilung (2) benutzt wird, so dass eine elektromagnetische Umgebung simuliert wird;
das Stressaufbringungssystem zum Festmachen einer Testprobe (9) in der Abschirmungsabteilung (2), und zum Aufbringen von Stress auf die Testprobe (9) benutzt wird;
das Datensammelsystem zum Sammeln von elektromagnetischen Umgebungsdaten in der Abschirmungsabteilung (2) und von einwirkenden Kraftdaten der Testprobe (9) nach dem Aufbringen von Stress darauf benutzt wird; und
das Steuerungssystem, das zum Steuern, gemäß einem vorgegebenen Testprogramm und den Daten, die von dem Datensammelsystem gesammelt werden, des elektromagnetischen Simulationssystems und des Stressaufbringungssystems benutzt wird, um einen Zuverlässigkeitstest an der Testprobe (9) durchzuführen;
**dadurch gekennzeichnet, dass** das Stressaufbringungssystem eine Ladevorrichtung (401), eine obere Verbindungsstange (402) und eine untere Verbindungsstange (403) umfasst, ein unteres Ende der oberen Verbindungsstange (402) und ein oberes Ende der unteren Verbindungsstange (403) beide mit Probenhalterungen (404) versehen sind, ein unteres Ende der unteren Verbindungsstange (403) mit der Abschirmungsabteilung (2) fest verbunden ist, ein oberes Ende der oberen Verbindungsstange (402) mit der Ladevorrichtung (401) verbunden ist, und die Ladevorrichtung (401) zum Aufbringen einer einwirkenden Kraft auf die Testprobe (9) benutzt wird; und die Probenhalterung (404) zum Fixieren der Testprobe (9) benutzt wird; und
die Ladevorrichtung (401) eine Spannungsaufbringungskomponente (408) und eine Druckaufbringungskomponente (409) umfasst, die Spannungsaufbringungskomponente (408) mit der oberen Verbindungsstange (402) über einen Hebel beweglich verbunden ist, und die Druckaufbringungskomponente (409) mit der oberen Verbindungsstange (402) fest verbunden ist.

2. Zuverlässigkeitstestvorrichtung zur Kopplung einer elektromagnetischen Umgebung und einer Stressumgebung nach Anspruch 1, **dadurch gekennzeichnet, dass** das elektromagnetische Simulationssystem einen Signalsimulator (304), einen Filter (303) und ein Strahlungsarray (301) umfasst, die sequentiell verbunden sind, das Strahlungsarray (301) innerhalb der Schutzabdeckung angeordnet ist, das Strahlungsarray (301) verschiedene Hornantennen (302) umfasst, und ein Sendeende der Hornantenne (302) der Testprobe (9) zugewandt ist; worin der Signalsimulator (304) zum Erzeugen von elektromagnetischen Signalen benutzt wird, die die elektromagnetische Umgebung simulieren, und der Filter (303) zum Ausfiltern von elektromagnetischen Signalen in einem Nicht-Zielfrequenzband benutzt wird.

3. Zuverlässigkeitstestvorrichtung zur Kopplung einer elektromagnetischen Umgebung und einer Stressumgebung nach Anspruch 1, **dadurch gekennzeichnet, dass** das Datensammelsystem ferner einen zweiten elektromagnetischen Strahlungsdetektor (305) umfasst, und der zweite elektromagnetische Strahlungsdetektor (305) zum Sammeln von elektromagnetischen Umgebungsdaten außerhalb der Abschirmungsabteilung (2) und zum Senden der elektromagnetischen Umgebungsdaten an das Steuerungssystem benutzt wird.

4. Zuverlässigkeitstestvorrichtung zur Kopplung einer elektromagnetischen Umgebung und einer Stressumgebung nach Anspruch 1, **dadurch gekennzeichnet, dass** die Abschirmungsabteilung (2) mit einer Schutzabdeckung versehen ist, und die Probenhalterung (404) innerhalb der Schutzabdeckung angeordnet ist.

5. Zuverlässigkeitstestvorrichtung zur Kopplung einer elektromagnetischen Umgebung und einer Stressumgebung nach Anspruch 1, **dadurch gekennzeichnet, dass** die Probenhalterung (404) mit zumindest einer Spannschraube und zumindest einer Gleitschutzschraube versehen ist, die Spannschraube zum Fixieren der Testprobe (9) benutzt wird, und die Gleitschutzschraube benutzt wird, um zu verhindern, dass die Testprobe (9) gleitet.

6. Zuverlässigkeitstestvorrichtung zur Kopplung einer elektromagnetischen Umgebung und einer Stressumgebung nach Anspruch 1, **dadurch gekennzeichnet, dass** das elektromagnetische Simulationssystem und das Stressaufbringungssystem unabhängig voneinander arbeiten.

7. Zuverlässigkeitstestvorrichtung zur Kopplung einer elektromagnetischen Umgebung und einer Stressumgebung nach Anspruch 6, **dadurch gekennzeichnet, dass** das Steuerungssystem ein elektromagnetisches Steuerungsmodul und ein Stresssteuerungsmodul umfasst; das elektromagnetische Steuerungsmodul und das Stresssteuerungsmodul elektrisch verbunden sind; und

das elektromagnetische Steuerungsmodul eine elektromagnetische Steuertafel (701) umfasst, die benutzt wird, um das elektromagnetische Steuerungsmodul anzuzeigen und zu steuern, und das Stresssteuerungsmodul eine Stresssteuertafel (702) umfasst, die benutzt wird, um das Stresssteuerungsmodul anzuzeigen und zu steuern.

8. Zuverlässigkeitstestvorrichtung zur Kopplung einer elektromagnetischen Umgebung und einer Stressumgebung nach einem der Ansprüche 1 bis 7, **dadurch gekennzeichnet, dass** die Abschirmungsabteilung (2) mit einer Vielzahl von Abteilungen versehen ist, jede von den Abteilungen mit dem elektromagnetischen Simulationssystem und dem Stressaufbringungssystem separat versehen ist, und es die Mikrowellenabsorptionsschicht (201) und die Abschirmungsschicht (202) zwischen angrenzenden Abteilungen gibt.

**Revendications**

1. Appareil de test de fiabilité pour coupler un environnement électromagnétique et un environnement de contrainte, comprenant : un compartiment de blindage (2), un système de simulation électromagnétique, un système d'application de contrainte, un système de collecte de données et un système de commande, dans lequel

un côté intérieur du compartiment de blindage (2) est doté d'une couche d'absorption de micro-ondes (201) et d'une couche de blindage (202) ;
le système de simulation électromagnétique sert à émettre des ondes électromagnétiques dans le compartiment de blindage (2), de manière à simuler un environnement électromagnétique ;
le système d'application de contrainte sert à fixer un échantillon à tester (9) dans le compartiment de protection (2) et à appliquer une contrainte à l'échantillon à tester (9) ;
le système de collecte de données sert à collecter des données d'environnement électromagnétique dans le compartiment de blindage (2) et des données de force d'action de l'échantillon à tester (9) après l'application d'une contrainte sur celui-ci ; et
le système de commande sert à commander, selon un programme de test prédéfini et les données collectées par le système de collecte de données, le système de simulation électromagnétique et le système d'application de contraintes afin d'exécuter un test de fiabilité sur l'échantillon à tester (9) ; **caractérisé en ce que**, le système d'application de contrainte comprend un appareil de chargement (401), une bielle supérieure (402) et une bielle inférieure (403), une extrémité inférieure de la bielle supérieure (402) et une extrémité supérieure de la bielle inférieure (403) sont toutes deux dotées de fixations d'échantillon (404), une extrémité inférieure de la bielle inférieure (403) est reliée solidement au compartiment de blindage (2), une extrémité supérieure de la bielle supérieure (402) est reliée à l'appareil de chargement (401), et l'appareil de chargement (401) sert à appliquer une force d'action sur l'échantillon à tester (9) ; et la fixation d'échantillon (404) sert à fixer l'échantillon à tester (9) ; et

l'appareil de chargement (401) comprend un composant d'application de tension (408) et un composant d'application de pression (409), le composant d'application de tension (408) est relié de manière mobile à la bielle supérieure (402) par l'intermédiaire d'un levier, et le composant d'application de pression (409) est relié solidement à la bielle supérieure (402).

2. Appareil de test de fiabilité pour coupler un environnement électromagnétique et un environnement de contrainte selon la revendication 1, **caractérisé en ce que** le système de simulation électromagnétique comprend un simulateur de signal (304), un filtre (303) et un réseau de rayonnement (301) qui sont reliés séquentiellement, le réseau de rayonnement (301) est disposé à l'intérieur du couvercle de protection, le réseau de rayonnement (301) comprend plusieurs antennes cornets (302), et une extrémité d'émission de l'antenne cornet (302) fait face à l'échantillon à tester (9) ;

dans lequel le simulateur de signaux (304) sert à générer des signaux électromagnétiques qui simulent l'environnement électromagnétique, et le filtre (303) sert à éliminer par filtrage les signaux électromagnétiques dans une bande de fréquences non cible.

3. Appareil de test de fiabilité pour coupler un environnement électromagnétique et un environnement de contrainte selon la revendication 1, **caractérisé en ce que** le système de collecte de données comprend en outre un second détecteur de rayonnement électromagnétique (305), et le second détecteur de rayonnement électromagnétique (305) sert à collecter des données d'environnement électromagnétique à l'extérieur du compartiment de blindage (2) et à transmettre les données d'environnement électromagnétique au système de commande.

4. Appareil de test de fiabilité pour coupler un environnement électromagnétique et un environnement de contrainte selon la revendication 1, **caractérisé en ce que** le compartiment de blindage (2) est doté d'un couvercle de protection, et la fixation d'échantillon (404) est disposée à l'intérieur du couvercle de protection.

5. Appareil de test de fiabilité pour coupler un environnement électromagnétique et un environnement de contrainte selon la revendication 1, **caractérisé en ce que** le dispositif de fixation d'échantillon (404) est doté d'au moins une vis de serrage et d'au moins une vis antidérapante, la vis de serrage sert à fixer l'échantillon à tester (9), et la vis antidérapante sert à empêcher l'échantillon à tester (9) de glisser.

6. Appareil de test de fiabilité pour coupler un environnement électromagnétique et un environnement de contrainte selon la revendication 1, **caractérisé en ce que** le système de simulation électromagnétique et le système d'application de contrainte fonctionnent indépendamment l'un de l'autre.

7. Appareil de test de fiabilité pour coupler un environnement électromagnétique et un environnement de contrainte selon la revendication 6, **caractérisé en ce que** le système de commande comprend un module de commande électromagnétique et un module de commande de contrainte ; le module de commande électromagnétique et le module de commande de contrainte sont connectés électriquement ; et

le module de commande électromagnétique comprend un panneau de commande électromagnétique (701) servant à afficher et à commander le module de commande électromagnétique, et le module de commande de contrainte comprend un panneau de commande de contrainte (702) servant à afficher et à commander le module de commande de contrainte.

8. Appareil de test de fiabilité pour coupler un environnement électromagnétique et un environnement de contrainte selon l'une quelconque des revendications 1 à 7, **caractérisé en ce que** le compartiment de blindage (2) est doté d'une pluralité de compartiments, chacun des compartiments est doté séparément du système de simulation électromagnétique et du système d'application de contrainte, et la couche d'absorption de micro-ondes (201) et la couche de blindage (202) sont présentes entre des compartiments adjacents.

FIG. 1

FIG. 2

FIG. 3

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 02056041 A1